Europäisches Patentamt

(19) European Patent Office

Office européen des brevets

(11) Publication number: **0 174 736 B1**

## (12) EUROPEAN PATENT SPECIFICATION

(45) Date of publication of the patent specification:
**29.11.89**

(21) Application number: **85305677.8**

(22) Date of filing: **09.08.85**

(51) Int. Cl.⁴: **G01R 19/165, H03K 5/24**

(54) Circuit for detecting level of input voltage.

(30) Priority: **10.08.84 JP 167480/84**

(43) Date of publication of application:
**19.03.86 Bulletin 86/12**

(45) Publication of the grant of the patent:
**29.11.89 Bulletin 89/48**

(84) Designated Contracting States:
**DE FR GB**

(56) References cited:
**WO-A-82/02262**

**PATENT ABSTRACTS OF JAPAN, vol. 8,
no. 167 (E-258)[1604], 2nd August 1984; & JP - A
-59 64 916 (TOSHIBA) 13-04-1984
PATENT ABSTRACTS OF JAPAN, vol. 5, no. 142 (P-79)
[814], 8th September 1981; & JP - A - 56 76 058 (DAINI
SEIKOSHA) 23-06-1981
PATENT ABSTRACTS OF JAPAN, vol. 6, no. 82,
(P-116)[960], 20th May 1982; & JP - A - 57 19 676 (SUWA
SEIKOSHA) 01-02-1982**

(73) Proprietor: **NEC CORPORATION, 33-1, Shiba 5-chome,
Minato-ku, Tokyo 108(JP)**

(72) Inventor: **Kobatake, Hiroyuki, c/o NEC Corporation 33-1,
Shiba 5-chome, Minato-ku Tokyo(JP)**

(74) Representative: **Pritchard, Colin Hubert et al, Mathys &
Squire 10 Fleet Street, London EC4Y 1AY(GB)**

Note: Within nine months from the publication of the mention of the grant of the European patent, any person may give notice to
the European Patent Office of opposition to the European patent granted. Notice of opposition shall be filed in a written reasoned
statement. It shall not be deemed to have been filed until the opposition fee has been paid (Art. 99(1) European patent
convention).

ACTORUM AG

## Description

The present invention relates to a circuit for detecting a level of an input voltage, and particularly to a level detection circuit composed of insulated gate field effect transistors.

A level detection circuit employing a ratio circuit and an inverter circuit has been proposed to detect the level of an input voltage, particularly to detect that the input voltage is larger in absolute value than a power supply voltage. The ratio circuit includes first and second insulated gate field effect transistors (IGFET's) connected in series between power supply terminals. The first IGFET is of an enhancement type and supplied with the input voltage, and the second IGFET is of a depletion type. The connection point of the first and second IGFET'S is an output terminal of the ratio circuit to which the inverter circuit is connected.

The output level of the ratio circuit is changed in accordance with the ratio of the internal impedances of the first and second IGFET's and the internal impedance of the first IGFET is controlled by the input voltage. When the output level of the ratio circuit exceeds the threshold level of the inverter circuit, the inverter circuit changes its output logic level.

Thus, the detection level of the input voltage is determined by the internal impedances of the first and second IGFET's and the threshold level of the inverter circuit. Accordingly, various detection levels of the input voltage can be designed with facility, and thus it is possible to generate the detection output when the input voltage exceeds the power supply voltage.

However, precise control of the threshold level of the inverter circuit is very difficult. Moreover, the internal impedances of the IGFET's depend on the threshold levels thereof, and it is also quite difficult to precisely determine the threshold levels of the IGFET's. As a result, the detection level of the input voltage deviates considerably from a designed value.

Another level detection circuit is disclosed in JP-A-59 64 916. An input voltage is supplied to a first IGFET and thus converted into a first current, and a reference voltage is supplied to a second IGFET and thus converted into a second current. The first current is compared with the second current by a current mirror circuit composed of third and fourth IGFETs. When the input voltage is larger than the reference voltage, the first current becomes larger than the second current, so that the output voltage takes a first logic level. On the other hand, when the input voltage is smaller than the reference voltage, the output voltage takes a second logic level. However, a detection level of the input voltage at which the logic level of the output voltage is inverted is determined only by the reference voltage, and it is impossible to set the detection level at various levels against the fixed reference voltage.

Therefore, an object of the present invention is to provide a level detection circuit in which the detection level of an input voltage can be designed arbitrarily without being affected by the deviation or variation of threshold levels of IGFETs.

A level detection circuit according to the present invention comprises a first input terminal for receiving an input voltage, a second input terminal for receiving a reference voltage, first means coupled to said first input terminal for converting said input voltage into a first current, a second means coupled to said second input terminal for converting said reference voltage into a second current, third means for comparing said first current with said second current to produce an output voltage, and an output terminal coupled to said third means to derive said output voltage therefrom, characterised in that said level detection circuit further comprises fourth means coupled between said first and third means for changing said first current to a third current representing said first current and fifth means coupled between said second and third means for changing said second current to a fourth current representing said second current, and that said third means compares said third current with said fourth current to produce said output voltage.

In the case where the input voltage is smaller in absolute value than the reference voltage, the first current is smaller than the second current. Assuming that the ratio of the third current to the first current and that of the fourth current to the second current are 1, respectively, the third current is also smaller than the fourth current. The output terminal thereby takes a first logic level. When the input voltage becomes larger in absolute value than the reference voltage, the first current becomes larger than the second current. The third current thereby takes a value larger than the fourth current. As a result, the output terminal is inverted from the first logic level to a second logic level.

Thus, the circuit according to the present invention detects the level of the input voltage by comparing the currents relative to the input voltage and the reference voltage. Such a current comparison circuit is stabilized against the deviation of and the change in threshold levels of IGFET's and the change in power supply voltage.

The detection level of the input voltage is controlled by the ratio between the first and third currents and/or that between the second and fourth currents. Accordingly, various detection levels can be designed with respect to the fixed reference voltage.

It is convenient to constitute each of the current changing means with a current mirror circuit. The current mirror circuit is composed of two IGFETs and produces an output current proportional to an input current, and the ratio of the output current to the input current is determined by the ratio in conductance between the IGFETs.

The invention will now be described, by way of example, with reference to the accompanying drawings, in which

Fig. 1 is a circuit diagram showing a level detection circuit according to prior art;

Fig. 2 is a graph representing a waveform of an output voltage $V_{OUT}$ with respect to an input voltage $V_{IN}$ in the circuit shown in Fig. 1;

Fig. 3 is a circuit diagram representing an embodiment of the present invention;

Fig. 4 is a graph for explaining an operation of the circuit shown in Fig. 3;

Fig. 5 is a graph representing a waveform of an output voltage $V_{OUT}$ with respect to an input voltage $V_{IN}$ in the circuit shown in Fig. 3; and

Fig. 6 is a circuit diagram showing another embodiment of the present invention.

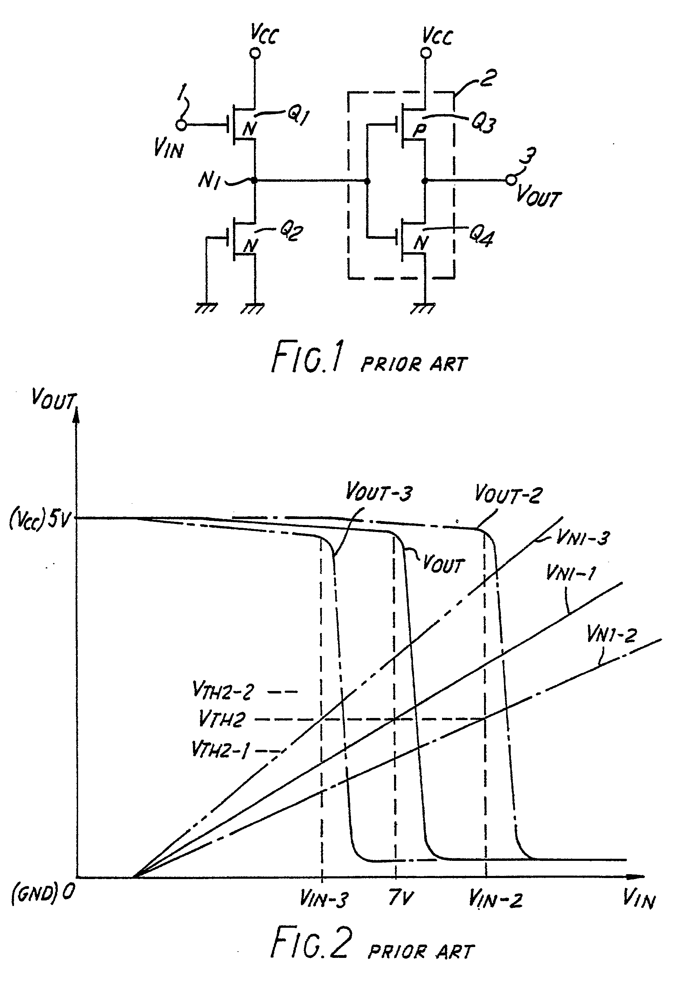

A level detection circuit according to prior art is shown in Fig. 1 to facilitate the understanding of the present invention. This circuit is composed of an enhancement MOS (Metal-Oxide-Semiconductor) transistor $Q_1$ of an N-channel type, a depletion MOS transistor $Q_2$ of the N-channel type, and an inverter 2. The transistors $Q_1$ and $Q_2$ are connected in series between power supply terminals $V_{CC}$ and GND. The gate of the transistor $Q_1$ is connected to an input terminal 1 supplied with an input voltage $V_{IN}$ to be detected, and the gate of the transistor $Q_2$ is grounded. The inverter 2 is composed of a P-channel MOS transistor $Q_3$ and an N-channel MOS transistor $Q_4$ connected in series between the power supply terminals $V_{CC}$ and GND. The gates of the transistors $Q_3$ and $Q_4$ are connected in common to the node $N_1$, and an output terminal 3 is connected to the connection point of the transistors $Q_3$ and $Q_4$.

In the case where the input voltage $V_{IN}$ is in a low level, i.e., in a ground level, the transistor $Q_1$ is in a nonconductive state. On the other hand, the transistor $Q_2$ is of the depletion type, and hence the node $N_1$ takes the ground level. As a result, the transistor $Q_3$ is turned ON and the output voltage $V_{OUT}$ takes a high level, i.e., a power supply voltage $V_{CC}$.

When the input voltage $V_{IN}$ rises to the threshold level of the transistor $Q_1$, the transistor $Q_1$ is brought into a conductive state. The potential at the node $N_1$ is thus determined by the ratio of the internal impedance of the transistor $Q_1$ to that of the transistor $Q_2$. The internal impedance of the transistor $Q_1$ is considerably high at the time when the input voltage $V_{IN}$ rises to the threshold level of the transistor $Q_1$, and therefore the potential at the node $N_1$ is near substantially to the ground level. The output voltage $V_{OUT}$ at the terminal 3 is thereby maintained to the high level.

The internal impedance of the transistor $Q_1$ is lowered by the increase in level of the input voltage $V_{IN}$, and the potential at the node $N_1$ is increased in response thereto. Accordingly, when the input voltage $V_{IN}$ increases to such a level that the potential at the node $N_1$ exceeds the threshold level of the inverter 2, the transistor $Q_4$ is turned ON to invert the output voltage $V_{OUT}$ to the low level.

Thus, the detection level of the input voltage $V_{IN}$ at which the output voltage $V_{OUT}$ changes from the high level to the low level, is determined by the internal impedance of the transistors $Q_1$ and $Q_2$ and the threshold level of the inverter 2. Accordingly, various detection levels of the input voltage $V_{IN}$ can be designed by adjusting these parameters.

In some of IC's (integrate circuit devices), there is further provided a test circuit for testing an operation of an internal signal processing circuit. In this case, the test circuit should not be activated in a normal operation state of the IC, and further one of the external lead terminals supplied with signals to be processed by the internal signal processing circuit is used in common as a terminal supplied with a testing voltage for activating the test circuit. The signal to be processed has a level amplitude changing between the power voltage $V_{CC}$ and the ground voltage GND. The testing voltage is therefore selected to take a level larger than the power voltage $V_{CC}$, whereby the testing voltage is distinguished from the signal to be processed. Accordingly, such a circuit is required, that produces an output signal in response only to the application of the testing voltage.

The circuit shown in Fig. 1 can be utilized for detecting the testing voltage. More specifically, the internal impedances of the transistors $Q_1$ and $Q_2$ are selected such that the potential $V_{N1}$ at the node $N_1$ exceeds the threshold level $V_{TH2}$ of the inverter 2 when the input voltage $V_{IN}$ is equal to or larger than 7 V, as shown in Fig. 2. The power supply voltage $V_{CC}$ is 5 V. In the normal operation, the voltage at the input terminal 1 does not become larger than the power supply voltage $V_{CC}$, and therefore the output voltage $V_{OUT}$ is maintained to the high level, as apparent from Fig. 2. On the other hand, the testing voltage for activating the internal test circuit has a level twice as large as the power supply voltage $V_{CC}$, 10 V. Accordingly, in response to the application of the testing voltage to the terminal 1, the potential $V_{N1}$ at the node $N_1$ exceeds the threshold level $V_{TH2}$ of the inverter 2 to invert the output voltage $V_{OUT}$ from the high level to the low level. The output terminal 3 is coupled to the internal test circuit, so that the test circuit is activated to test the operation of the internal signal processing circuit.

However, it is very difficult to precisely control the internal impedances of the transistors $Q_1$ and $Q_2$. Particularly, the transistor $Q_1$ is of an enhancement type and the transistor $Q_2$ is a depletion type, and therefore the deviation from the designed impedance of the transistor $Q_1$ occurs independently of the deviation from the designed impedance of the transistor $Q_2$. As a result, the rate of change in the potential $V_{NI}$ at the node $N_1$ is unavoidably deviated from the designed rate $V_{N1-1}$, which is represented by $V_{N1-2}$ or $V_{N1-3}$ in Fig. 2. The level of the input voltage $V_{IN}$ at which the output voltage $V_{OUT}$ changes to the low level is thereby shifted to the level $V_{IN-2}$ or $V_{IN-3}$, as shown in Fig. 2. If the level $V_{IN-2}$ is larger than 10 V, the testing voltage is not detected. In the case where the level $V_{IN-3}$ is smaller than the power voltage $V_{CC}$, the output voltage $V_{OUT}$ taking the low level is produced even when the IC attains the normal operation.

The threshold level $V_{TH2}$ of the inverter 2 is also deviated from the designed value, as represented by 5 $V_{TH2-1}$ or $V_{TH2-2}$ in Fig. 2, resulting in change in level of the input voltage $V_{IN}$ at which the output voltage $V_{OUT}$ is inverted to the low level.

As described above, the detect level of the circuit according to prior art is not stabilized against the deviations from the designed impedances of the transistors $Q_1$ and $Q_2$ and from the designed threshold level of the inverter 2.

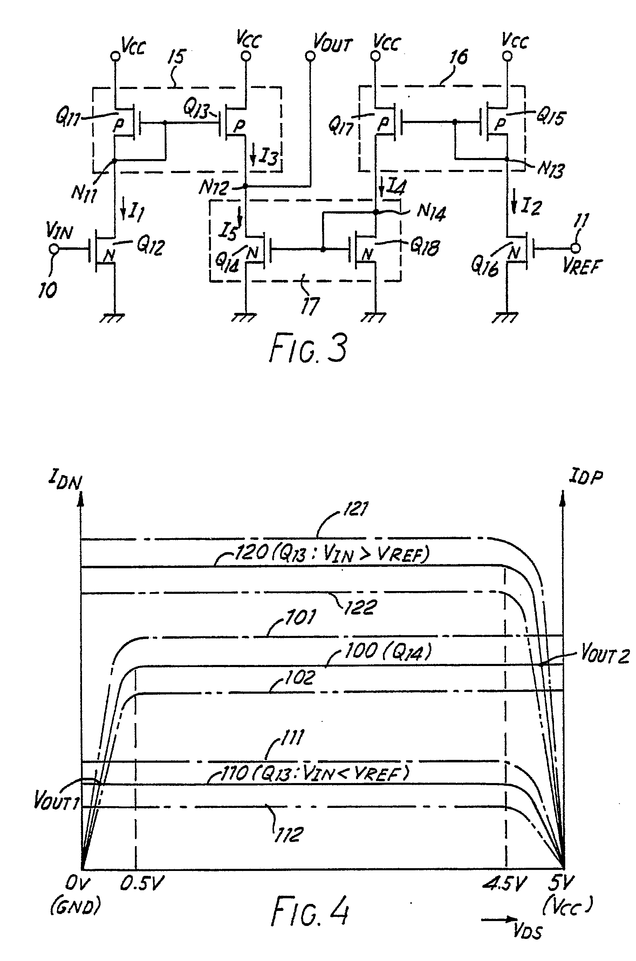

Referring to Fig. 3, there is shown a level detection circuit according to an embodiment of the present invention. This circuit is composed of complementary MOS transistors. An input voltage $V_{IN}$ to be detected is supplied to a first input terminal 10 which is in turn connected to the gate of an N-channel MOS transistor $Q_{12}$. The transistor $Q_{12}$ is connected between a ground terminal and a first node $N_{11}$, and thus converts the input voltage $V_{IN}$ into a first current $I_1$ relative to the level of the input voltage $V_{IN}$. A second input terminal 11 receives a reference voltage $V_{REF}$ and is connected to the gate of an N-channel MOS transistor $Q_{16}$ connected between the ground terminal and a third node $N_{13}$. The reference voltage $V_{REF}$ is converted into a second current $I_2$ by the transistor $Q_{16}$.

The first current $I_1$ is supplied as an input current to a first current mirror circuit 15 composed of two P-channel MOS transistors $Q_{11}$ and $Q_{13}$. The transistor $Q_{11}$ is connected between the node $N_{11}$ and a power voltage supply terminal $V_{CC}$ and the gate thereof is connected to the node $N_{11}$ and further connected to the gate of the transistor $Q_{13}$. The transistor $Q_{13}$ is connected between the power terminal $V_{CC}$ and a second node $N_{12}$. Thus, the gates and sources of the transistors $Q_{11}$ and $Q_{13}$ are connected in common, respectively, and the gate of the transistor $Q_{11}$ is connected to its drain. Therefore, the first current mirror circuit 15 produces a third current $I_3$ proportional to the first current $I_1$. Assuming that the conductances of the transistors $Q_{11}$ and $Q_{13}$ are $G_{m11}$ and $G_{m13}$, respectively, the third current $I_3$ is as follows:

$I_3 = I_1 \times (G_{m13}/G_{m11})$ (1)

The second current $I_2$ is supplied to a second current mirror circuit 16 composed of two P-channel MOS transistors $Q_{15}$ and $Q_{17}$. The transistor $Q_{15}$ is connected between the power terminal $V_{CC}$ and the third node $N_{13}$, and the gate thereof is connected to the node $N_{13}$. The gate of the transistor $Q15$ is further connected to the gate of the transistor $Q_{17}$ connected between the power terminal $V_{CC}$ and a fourth node $N_{14}$. The second current mirror circuit 16 thus produces a fourth current $I_4$ proportional to the second current $I_2$. When the conductances of the transistors $Q_{15}$ and $Q_{17}$ are $G_{m15}$ and $G_{m17}$, respectively, the fourth current $I_4$ takes the following value:

$I_4 = I_2 \times (G_{m17}/G_{m15})$ (2)

The fourth current $I_4$ is supplied to a third current mirror circuit 17 as its input current, which is composed two N-channel MOS transistors $Q_{18}$ and $Q_{14}$. The transistor $Q_{18}$ is connected between the fourth node $N_{14}$ and the ground terminal. The gate of the transistor $Q_{18}$ is connected to the node $Q_{14}$ and further connected to the gate of the transistor $Q_{14}$ which is in turn connected between the second node $N_{12}$ and the ground terminal. Assuming that the conductances of the transistors $Q_{14}$ and $Q_{18}$ are $G_{m14}$ and $G_{m18}$, respectively, the third current mirror circuit 17 responds to the fourth current $I_4$ and produces a fifth current $I_5$ taking the following value:

$I_5 = I_4 \times (G_{m14}/G_{m18})$ (3)

The second node $N_{12}$ is further connected to an output terminal 12 from which a detection output $V_{OUT}$ is derived. All the transistors $Q_{11}$ to $Q_{18}$ are of an enhancement type.

In operation, the transistor $Q_{16}$ responds to the reference voltage $V_{REF}$ and produces the second current $I_2$ relative to the level of $V_{REF}$. Assuming that $G_{m15} = G_{m17}$ and that $G_{m18} = G_{m14}$, the fourth and fifth currents $I_4$ and $I_5$ become equal to the second current $I_2$, as apparent from the equations (2) and (3). In other words, the same current as the second current $I_2$ flows into the transistors $Q_{15}$, $Q_{17}$ and $Q_{18}$, respectively, and the transistor $Q_{14}$ is biased so as to draw the current equal to the second current $I_2$ from the node $N_{12}$. As a result, the characteristic of the drain current $I_{DN}$ to the drain-source voltage $V_{DS}$ of the transistor $Q_{14}$ is represented by a line 100 in Fig. 4.

On the other hand, the input voltage $V_{IN}$ is converted into the first current $I_1$ by the transistor $Q_{12}$. Assuming that the conductances of the transistors $Q_{12}$ and $Q_{16}$ are equal to each other, the first current $I_1$ becomes smaller than the second current $I_2$ when the input voltage $V_{IN}$ is smaller than the reference voltage $V_{REF}$. If the conductance of the transistor $Q_{11}$ is equal to that of the transistor $Q_{13}$ ($G_{m11} = G_{m13}$), the third current $I_3$ becomes equal to the first current $I_1$. To the contrary, the transistor $Q_{14}$ as the ability to draw the current equal to the second current $I_2$. Accordingly, the characteristic of the drain current $I_{DP}$ to the drain-source voltage $V_{DS}$ of the transistor $Q_{13}$ is shown by a line 110 in Fig. 4. As apparent from Fig. 4, the line 110 intersects with the line 100 in the unsaturated region of the transistor $Q_{14}$. As a result, the voltage level $V_{OUT1}$ at the intersection of the lines 100 and 110 is produced as the output voltage $V_{OUT}$. The level of $V_{OUT1}$ is substantially the low level, i.e., the ground level as shown in Fig. 4. In other words, since the transistor $Q_{13}$ has only the ability to supply the current smaller than the second current $I_2$ which the transistor $Q_{14}$ can draw, the drain-source voltage of the transistor $Q_{14}$ is lowered, so that the output voltage $V_{OUT}$ takes the $V_{OUT1}$ level.

In accordance with the increase in level of the input voltage $V_{IN}$, the current $I_1$ (i.e., $I_3$) is increased, so that the intersection of the lines 100 and 110 changes along the line 100. However, so long as the input voltage $V_{IN}$ is smaller than the reference voltage $V_{REF}$, the intersection of the lines 100 and 110 exists in the unsaturated region of the transistor $Q_{14}$. Accordingly, the output voltage $V_{OUT}$ changes only

from 0 V to 0.5 V. These levels are regarded as the low level.

When the input voltage $V_{IN}$ becomes equal to the reference voltage $V_{REF}$, the currents flowing through all the transistors $Q_{11}$ to $Q_{18}$ are equal to one another. Accordingly, the lines 100 and 110 overlap with each other in their straight portions. As a result, the output voltage $V_{OUT}$ takes an intermediate level between the power voltage $V_{CC}$ and the ground voltage GND.

When the input voltage $V_{IN}$ becomes larger even slightly than the reference voltage $V_{REF}$, the first current $I_1$ takes a value larger than the second current $I_2$. The current supply ability of the transistor $Q_{13}$ is thereby made larger than the current draw ability of the transistor $Q_{14}$. Accordingly, the characteristic of the drain current $I_{DP}$ to the drain-source voltage $V_{DS}$ of the transistor $Q_{13}$ is changed from the line 110 to a line 120 as shown in Fig. 3. In other words, the intersection of the lines 100 and 120 exists in the unsaturated region of the transistor $Q_{13}$. As a result, the output voltage $V_{OUT}$ takes a second level $V_{OUT2}$ which is near substantially to the power supply voltage $V_{CC}$. The difference between the second level $V_{OUT2}$ and the power voltage $V_{CC}$ is only 0.5 V in a maximum value as shown in Fig. 4, and it is decreased by the increase of the input voltage $V_{IN}$. Therefore, the second level $V_{OUT}$ is regarded as the high level.

As described above, assuming that $G_{m11} = G_{m13}$, $G_{m12} = G_{m16}$, $G_{m14} = G_{m18}$, and $G_{m15} = G_{m17}$, the output voltage $V_{OUT}$ changes the low level to the high level, when the input voltage $V_{IN}$ exceeds the reference voltage $V_{REF}$. The ratio in conductances of two transistors in pair, $Q_{11}$ and $Q_{13}$, $Q_{12}$ and $Q_{16}$, $Q_{14}$ and $Q_{18}$, and $Q_{15}$ and $Q_{17}$, is controlled by the geometrical dimensions of the respective transistors.

The respective conductances of the transistors $Q_{11}$ to $Q_{18}$ may be changed by the deviation from the designed threshold levels of the transistors $Q_{11}$ to $Q_{18}$. However, two transistors in pair, $Q_{11}$ and $Q_{13}$, $Q_{12}$ and $Q_{16}$, $Q_{14}$ and $Q_{18}$, and $Q_{15}$ and $Q_{17}$, are of the same channel type, and both of the transistors in pair are of an enhancement type. Accordingly, if the threshold level of one of the transistors in pair is deviated from the designed value, the threshold level of the other transistor is also deviated from the designed value by the same value. The ratio in conductances of two transistors in pair is thereby maintained constantly. As a result, if the line 100 is shifted to a line 101 or 102, the line 110 is shifted to a line 111 or 112, respectively, by the same value. The line 120 is also shifted to a line 121 or 122, respectively. In other words, the ratio of the current convertion rate of the input voltage $V_{IN}$ by the transistor $Q_{12}$ to that of the reference voltage $V_{REF}$ by the transistor $Q_{16}$ is stabilized, and the ratios between the currents $I_1$ and $I_3$, between those $I_2$ and $I_4$, and between those $I_4$ and $I_5$ are also stabilized.

Moreover, the detection level of the input voltage $V_{IN}$ can be changed arbitrary by adjusting the ratio in conductances of the transistors in pair. For example, by selecting the ratio in conductances such that $G_{m12} < G_{m16}$, $G_{m11} > G_{m13}$, $G_{m14} > G_{m18}$, or $G_{m17} > G_{m15}$, the detection level of the input voltage $V_{IN}$ becomes larger than the reference voltage $V_{REF}$.

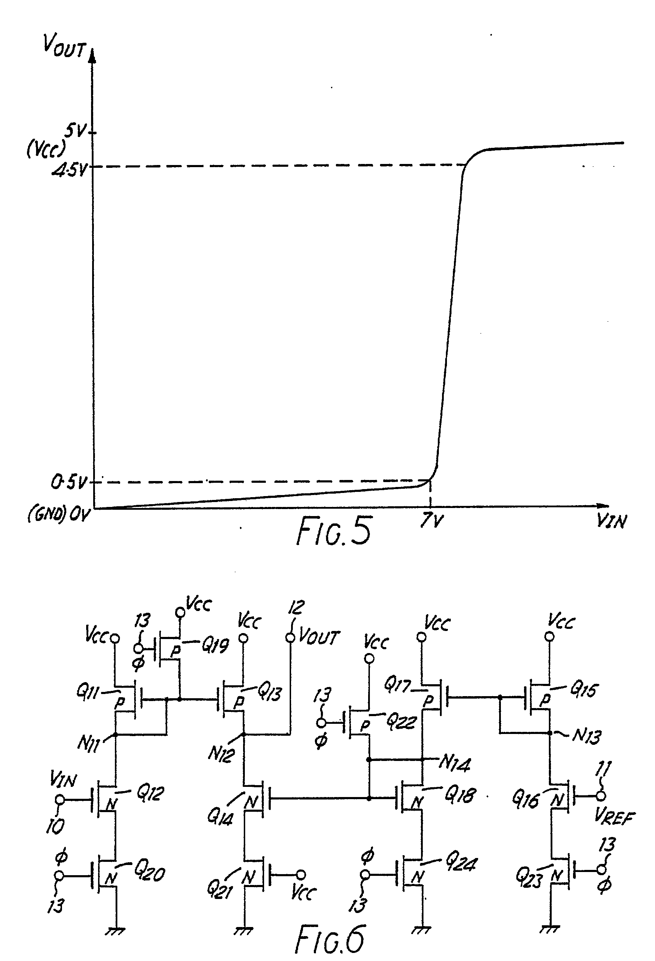

The circuit shown in Fig. 3 is also utilized for detecting the afore mentioned testing voltage. In this case, the second input terminal 11 is connected to the power supply terminal $V_{CC}$, and the ratio of the conductance of the transistor $Q_{14}$ to that of the transistor $Q_{18}$ is selected to 1.5:1. The ratios in conductances between the transistors $Q_{11}$ and $Q_{13}$, $Q_{12}$ and $Q_{16}$, and $Q_{15}$ and $Q_{17}$ are designed to be 1, respectively. According to these circuit designs, even when the input voltage $V_{IN}$ takes the power supply voltage $V_{CC}$, the current draw ability of the transistor $Q_{14}$ is larger than the current supply ability of the transistor $Q_{13}$, so that the output voltage is maintained to the low level, as shown in Fig. 5. When the input voltage $V_{IN}$ increases to 7 V, the output voltage $V_{OUT}$ starts to change its level. The output voltage $V_{OUT}$ is inverted quickly from the low level to the high level, when the input voltage $V_{IN}$ exceed 7 V. Accordingly, the testing voltage is detected. The level of the input voltage $V_{IN}$ at which the output voltage is inverted, 7 V, is stabilized against the deviation from the designed threshold level of each transistor, as already mentioned.

The input voltage $V_{IN}$ and the reference voltage $V_{REF}$ can be supplied to the second terminal 11 and the first terminal 10, respectively. In this case, the output voltage $V_{OUT}$ is changed from the high level to the low level, when the input voltage $V_{IN}$ exceeds a predetermined detection level.

Fig. 6 shows another embodiment of the present invention, in which the same constituents as those shown in Fig. 3 are denoted by the same references. This circuit further includes two P-channel MOS transistors $Q_{19}$ and $Q_{22}$, and four N-channel MOS transistors $Q_{20}$, $Q_{21}$, $Q_{23}$ and $Q_{24}$, and each of these transistors is of an enhancement type. The transistor $Q_{19}$ is connected between the power terminal $V_{CC}$ and the first node $N_{11}$, and the gate thereof is connected to a control terminal 13. The transistor $Q_{22}$ is connected between the power supply terminal $V_{CC}$ and the fourth node $N_{14}$, and the gate thereof is connected to the control terminal 13. The transistor $Q_{20}$ has its gate connected to the control terminal 13 and is inserted between the transistor $Q_{12}$ and the ground terminal. The transistor $Q_{21}$ is inserted between the transistor $Q_{14}$ and the ground terminal. The gate of the transistor $Q_{21}$ is supplied with the power voltage $V_{CC}$. The transistor $Q_{23}$ is inserted between the transistor $Q_{16}$ and the ground terminal and has its gate connected to the control terminal 13. The transistor $Q_{24}$ is connected between the transistor $Q_{18}$ and the ground terminal, and the gate of the transistor $Q_{24}$ is connected to the control terminal 13. The control terminal 13 is supplied with a control signal $\varnothing$.

The circuit shown in Fig. 6 is switched over between the stand-by mode and the activated mode by

the control signal ∅. More specifically, when this circuit is brought into the stand-by mode, i.e., when the control signal ∅ takes the low level, the transistors $Q_{19}$ and $Q_{22}$ are turned ON, whereas the transistors $Q_{20}$, $Q_{23}$ and $Q_{24}$ are turned OFF. The transistors $Q_{11}$ and $Q_{13}$ are thereby brought into the nonconductive state. The transistor $Q_{14}$ is turned ON by the transistor $Q_{22}$, and the transistor $Q_{21}$ is in the conductive state. Accordingly, this circuit does not carry out the level detection operation, and the output voltage $V_{OUT}$ is held to the low level. Moreover, the transistors $Q_{20}$, $Q_{13}$, $Q_{23}$ and $Q_{24}$ are in the nonconductive state, and therefore no d.c. current path is formed between the power supply terminals $V_{CC}$ and GND, so that a power dissipation in the stand-by mode is remarkably reduced.

When the control signal ∅ of changes to the high level, the transistors $Q_{19}$ and $Q_{22}$ are turned OFF, and the transistors $Q_{20}$, $Q_{23}$ and $Q_{24}$ are turned ON. As a result, this circuit is in the activated state to carry out the level detection operation, similarly to the circuit shown in Fig. 2. It is preferable that the conductances of the transistors $Q_{20}$, $Q_{21}$, $Q_{23}$ and $Q_{24}$ are sufficiently high to neglect the insertion of these transistors.

The transistor $Q_{21}$ may be omitted, because it is maintained in the conductive state during the stand-by mode as well as the activated mode. However, in order to obtain the symmetry between a current path including the transistors $Q_{18}$ and $Q_{24}$ and that including the transistor $Q_{14}$, the transistor $Q_{21}$ is provided.

As already mentioned, the second input terminal may be connected to the power terminal $V_{CC}$. In this case, the detection output is produced when the input voltage $V_{IN}$ exceeds the power voltage $V_{CC}$, and therefore this circuit can be applied to thest circuit. This circuit is also applicable to a write circuit in an electrically programmable read only memory device (EPROM). The input voltage $V_{IN}$ and the reference $V_{REF}$ may be supplied to the second terminal 11 and the first terminal 10, respectively.

This invention is not limited to the above-mentioned embodiments, for example, the channel types of the respective transistors may be changed.

## Claims

1. A level detection circuit comprising a first input terminal (10) for receiving an input voltage ($V_{IN}$), a second input terminal (11) for receiving a reference voltage ($V_{REF}$), first means ($Q_{12}$) coupled to said first input terminal (10) for converting said input voltage ($V_{IN}$) into a first current ($I_1$), a second means ($Q_{16}$) coupled to said second input terminal (11) for converting said reference voltage ($V_{REF}$) into a second current ($I_2$), third means (17) for comparing said first current ($I_1$) with said second current ($I_2$) to produce an output voltage ($V_{OUT}$), and an output terminal (12) coupled to said third means (17) to derive said output voltage ($V_{OUT}$) therefrom, characterised in that said level detection circuit further comprises fourth means (15) coupled between said first and third means (Q12, 17) for changing said first current ($I_1$) to a third current ($I_3$) representing said first current ($I_1$) and fifth means (16) coupled between said second and third means (Q16, 17) for changing said second current ($I_2$) to a fourth current ($I_4$) representing said second current ($I_2$), and that said third means (17) compares said third current ($I_3$) with said fourth current ($I_4$) to produce said output voltage ($V_{OUT}$).

2. The circuit as claimed in claim 1, characterised in that said fourth means (15) comprises a first current mirror circuit having an input node ($N_{11}$) for receiving said first current ($I_1$) and an output node ($N_{12}$) for outputting said third current ($I_3$), and said fifth means comprises a second current mirror circuit having an input node ($N_{13}$) for receiving said second current ($I_2$) and an output node ($N_{14}$) for outputting said fourth current ($I_4$), said third means (17) comprising a third current circuit having an input node connected to the output node of one of said first and second current mirror circuits (15, 16) and an output node connected to the output node of the other of said first and second current mirror circuits (15, 16), said output terminal (12) being connected to the output node of said third current mirror circuit (17).

3. The circuit as claimed in claim 2, characterised in that said first current mirror circuit (15) includes first and second transistors ($Q_{11}$, $Q_{13}$) of one conductivity type and said second current mirror circuit (16) includes third and fourth transistors ($Q_{15}$, $Q_{17}$) of said one conductivity type, said third current mirror circuit (17) including fifth and sixth transistors ($Q_{14}$, $Q_{15}$) of an opposite conductivity type.

4. The circuit as claimed in claim 1, 2 or 3, characterised by first control means ($Q_{20}$) responsive to a control signal (∅) for enabling said first means ($Q_{12}$) to convert said input voltage ($V_{IN}$) into said first current ($I_1$) and second control means ($Q_{23}$) responsive to said control signal (∅) for enabling said second means ($Q_{16}$) to convert said reference voltage ($V_{REF}$) into said second current ($I_2$).

5. The circuit as claimed in claim 1, 2, 3 or 4, characterised in that a power supply voltage ($V_{cc}$) is supplied to said second input terminal (11) as said reference voltage ($V_{REF}$).

## Patentansprüche

1. Niveaunachweisschaltung mit einem ersten Eingangsanschluß (10) zum Empfangen einer Eingangsspannung ($V_{IN}$), mit einem zweiten Eingangsanschluß (11) zum Empfangen einer Bezugsspannung ($V_{REF}$), mit einem ersten Mittel ($Q_{12}$), das an den ersten Eingangsanschluß (10) gekoppelt ist, um die erste Eingangsspannung ($V_{IN}$) in einen ersten Strom ($I_1$) umzuwandeln, mit einem zweiten Mittel ($Q_{16}$), das an den zweiten Eingangsanschluß (11) gekoppelt ist, um die Bezugsspannung ($V_{REF}$) in einen zweiten Strom ($I_2$) umzuwandeln, mit einem dritten Mittel (17) zum Vergleichen des ersten Stroms ($I_1$) mit dem zweiten Strom ($I_2$), um eine Ausgangsspannung ($V_{OUT}$) zu erzeugen, und mit einem Ausgangsanschluß (12), der an das dritte Mittel (17) gekoppelt ist, um von diesem die Ausgangsspannung (V$_{OUT}$) zu erhalten, dadurch gekennzeichnet, daß die Niveaunachweisschaltung ein viertes Mittel (15), das zwischen dem ersten und dem dritten Mittel (Q12, 17) gekoppelt ist, um den ersten Strom (I$_1$) in einen den ersten Strom (I$_1$) repräsentierenden dritten Strom (I$_3$) zu ändern und ein fünftes Mittel (16), das zwischen dem zweiten und dritten Mittel (Q16, 17) gekoppelt ist, um den zweiten Strom (I$_2$) in einen den zweiten Strom (I$_2$) repräsentierenden vierten Strom (I$_4$) zu ändern, umfaßt, und daß das dritte Mittel (17) den dritten Strom (I$_3$) mit dem vierten Strom (I$_4$) vergleicht, um die Ausgangsspannung (V$_{OUT}$) zu erzeugen.

2. Schaltung nach Anspruch 1, dadurch gekennzeichnet, daß das vierte Mittel (15) eine erste Stromspiegelschaltung mit einem Eingangsknotenpunkt (N$_{11}$) zum Empfangen des ersten Stroms (I$_1$) und einen Ausgangsknotenpunkt (N$_{12}$) zum Ausgeben des dritten Stroms (I$_3$) umfaßt, und das fünfte Mittel eine zweite Stromspiegelschaltung mit einem Eingangsknotenpunkt (N$_{13}$) zum Empfangen des zweiten Stroms (I$_2$) und einen Ausgangsknotenpunkt (N$_{14}$) zum Ausgeben des vierten Stroms (I$_4$) umfaßt, wobei das dritte Mittel (17) eine dritte Stromschaltung mit einem Eingangsknotenpunkt, der an den Ausgangsknotenpunkt von einer der ersten und zweiten Stromspiegelschaltungen (15, 16) angeschlossen ist und einen Ausgangsknotenpunkt, der an den Ausgangsknotenpunkt von der anderen der ersten und zweiten Stromspiegelschaltungen (15, 16) angeschlossen ist, umfaßt, wobei der Ausgangsanschluß (12) an den Ausgangsknotenpunkt der dritten Stromspiegelschaltung (17) angeschlossen ist.

3. Schaltung nach Anspruch 2, dadurch gekennzeichnet, daß die erste Stromspiegelschaltung (15) erste und zweite Transistoren (Q$_{11}$, Q$_{13}$) von einer Leitungsart umfaßt und die zweite Stromspiegelschaltung (16) dritte und vierte Transistoren (Q$_{15}$, Q$_{17}$) von dieser einen Leitungsart umfaßt, wobei die dritte Stromspiegelschaltung (17) fünfte und sechste Transistoren (Q$_{14}$, Q$_{15}$) von einer entgegengesetzten Leitungsart umfaßt.

4. Schaltung nach Anspruch 1, 2 oder 3, gekennzeichnet durch ein erstes Steuermittel (Q$_{20}$), das ansprechend auf ein Steuersignal (Ø) ist, um das erste Mittel (Q12) zu befähigen, die Eingangsspannung (V$_{IN}$) in den ersten Strom (I$_1$) umzuwandeln, und durch ein zweites Steuermittel (Q$_{23}$), das ansprechend auf das Steuersignal (Ø) ist, um das zweite Mittel (Q16) zu befähigen, die Bezugsspannung (V$_{REF}$) in den zweiten Strom (I$_2$) umzuwandeln.

5. Schaltung nach Anspruch 1, 2, 3 oder 4, dadurch gekennzeichnet, daß eine Netzspannung (V$_{cc}$) an dem zweiten Eingangsanschluß (11) als die Bezugsspannung (V$_{REF}$) angelegt ist.

## Revendications

1. Circuit de détection de niveau comprenant une première borne d'entrée (10) pour recevoir une tension d'entrée (V$_{IN}$), une seconde borne d'entrée (11) pour recevoir une tension de référence (V$_{REF}$), un premier moyen (Q12) relié à la première borne d'entrée (10) pour transformer la tension d'entrée (V$_{IN}$) en un premier courant (I$_1$), un second moyen (Q16) relié à la seconde borne d'entrée (11) pour transformer la tension de référence (V$_{REF}$) en un second courant (I$_2$), un troisième moyen (17) pour comparer le premier courant (I$_1$) au second courant (I$_2$) et produire une tension de sortie (V$_{OUT}$), et une borne de sortie (12) reliée au troisième moyen (17) pour obtenir la tension de sortie (V$_{OUT}$) à partir de celle-ci, caractérisé en ce que le circuit de détection de niveau comprend en outre un quatrième moyen (15) monté entre les premier et troisième moyens (Q12, 17) pour transformer le premier courant (I$_1$) en un troisième courant (I$_3$) représentant le premier courant (I$_1$) et un cinquième moyen (16) monté entre les second et troisième moyens (Q16, 17) pour transformer le second courant (I$_2$) en un quatrième courant (I$_4$) représentant le second courant (I$_2$), et en ce que le troisième moyen (17) compare le troisième courant (I$_3$) au quatrième courant (I$_4$) pour produire la tension de sortie (V$_{OUT}$).

2. Circuit selon la revendication 1, caractérisé en ce que le quatrième moyen (15) comprend un premier circuit à courant en rapport géométrique ayant un nœud d'entrée (N$_{11}$) pour recevoir le premier courant (I$_1$) et un nœud de sortie (N$_{12}$) pour sortir le troisième courant (I$_3$), et le cinquième moyen comprend un second circuit à courant en rapport géométrique ayant un nœud d'entrée (N$_{13}$) pour recevoir le second courant (I$_2$) et un nœud de sortie (N$_{14}$) pour sortir le quatrième courant (I$_4$), le troisième moyen (17) comprenant un troisième circuit à courant ayant un nœud d'entrée relié au nœud de sortie de l'un des premier et second circuits à courant en rapport géométrique (15, 16) et un nœud de sortie relié au nœud de sortie de l'autre des premier et second circuits à courant en rapport géométrique (15, 16), la borne de sortie (12) étant reliée au nœud de sortie du troisième circuit à courant en rapport géométrique (17).

3. Circuit selon la revendication 2, caractérisé en ce que le premier circuit à courant en rapport géométrique (15) comprend des premier et second transistors (Q$_{11}$, Q$_{13}$) d'un type de conductivité et le second circuit à courant en rapport géométrique (16) comporte des troisième et quatrième transistors (Q$_{15}$, Q$_{17}$) de ce type de conductivité, le troisième circuit à courant en rapport géométrique (17) comprenant des cinquième et sixième transistors (Q$_{14}$, Q$_{15}$) d'un type de conductivité opposé.

4. Circuit selon la revendication 1, 2 ou 3, caractérisé par un premier moyen de commande (Q$_{20}$) répondant à un signal de commande (Ø) pour permettre au premier moyen (Q12) de transformer la tension d'entrée (V$_{IN}$) afin de donner le premier courant (I$_1$) et un second moyen de commande (Q$_{23}$) répondant au signal de commande (Ø) pour permettre au second moyen (Q16) de transformer la tension de référence (V$_{REF}$) afin d'obtenir le second courant (I$_2$).

5. Circuit selon la revendication 1, 2, 3 ou 4, caractérisé en ce qu'une tension d'alimentation (V$_{cc}$) est fournie à la seconde borne d'entrée (11) comme tension de référence (V$_{REF}$).

FIG.1 PRIOR ART

FIG.2 PRIOR ART

FIG. 3

FIG. 4

Fig.5

Fig.6